# EUROPÄISCHE PATENTSCHRIFT

(11) **EP 3 074 781 B1**
(45) Veröffentlichungstag und Bekanntmachung des Hinweises auf die Patenterteilung: **17.06.2020**
(21) Anmeldenummer: 14799444.6
(22) Anmeldetag: 17.11.2014
(51) Int. Cl.: G01R 31/12, G01R 31/08, G01R 31/11

(54) **VERFAHREN UND EINRICHTUNG ZUR ORTUNG VON TEILENTLADUNGEN IN ELEKTRISCHEN KABELN**
METHOD AND DEVICE FOR LOCATING PARTIAL DISCHARGES IN ELECTRIC CABLES
PROCÉDÉ ET DISPOSITIF DE LOCALISATION DE DÉCHARGES PARTIELLES DANS DES CÂBLES ÉLECTRIQUES

(30) Priorität: 29.11.2013 DE 102013224573
(43) Veröffentlichungstag der Anmeldung: 05.10.2016
(73) Patentinhaber: Hagenuk KMT Kabelmesstechnik GmbH, 01471 Radeburg (DE)
(72) Erfinder: MARKALOUS, Sacha, 01445 Radebeul (DE); KÜTTNER, Marco, 01159 Dresden (DE)
(74) Vertreter: Kailuweit & Uhlemann Patentanwälte Partnerschaft mbB
(86) Internationale Anmeldenummer: PCT/EP2014/074755
(87) Internationale Veröffentlichungsnummer: WO 2015/078716

(56) Entgegenhaltungen:
- US-A1- 2009 119 035
- US-A1- 2009 177 420
- US-A1- 2010 253 364
- US-A1- 2013 211 750

## Beschreibung

Die Erfindung betrifft Verfahren und Einrichtungen zur Ortung von Teilentladungen in elektrischen Kabeln mit einer an das zu prüfende Kabel gekoppelten Hochspannungsquelle, einer an ein Ende des Kabels angeschlossenen Auskoppeleinheit und einem über eine Sensoreinheit mit der Auskoppeleinheit verbundenen und aus den Sensorsignalen bei Vorhandensein eine Teilentladung oder Teilentladungen ermittelnden Datenverarbeitungssystem.

Das frühzeitige Erkennen von Schwachstellen an elektrischen Hochspannungskabeln ist für Energieversorger wichtig, um die Ausfallzeiten der Kabel möglichst gering zu halten. Ein möglicher Frühindikator für den Ausfall eines Hochspannungskabels ist das Auftreten von Teilentladungen. Um den Fehlerort innerhalb des Kabels einzugrenzen, ist nicht nur die Detektion von Teilentladungen wichtig, sondern auch deren Entstehungsort zu kennen.

Durch die Druckschrift DE 37 37 373 A1 ist ein Verfahren und eine Schaltungsanordnung zur Isolationsprüfung von Prüflingen mit großer Eigenkapazität und zur Ortung von Fehlern in Energiekabeln bekannt. Dabei wird ein Hochspannugs-Transformator eingesetzt, an dessen Primärseite ein Ladekondensator und mit unterschiedlicher Frequenz gesteuerte Halbleiter vorgesehen sind. An der Sekundärseite ist ein synchrongeschalteter Demodulator geschalten. Zur Messung ist das zu messende Energiekabel ein Bestandteil eines Stromkreises. Es handelt sich um ein analoges Verfahren mit einer manuellen Auswertung der Messergebnisse.

Das Grundproblem bei der Ortung von Teilentladungen liegt vor allem darin, dass für eine hohe Ortsauflösung hohe Bandbreiten vorhanden sind und für die meist digitale Verarbeitung hohe Datenmengen anfallen. Die hohen Datenmengen entstehen vor allem dabei, dass Teilentladungen zufällig auftreten. Im Voraus ist kaum abzuschätzen, ob in einem bestimmten Zeitintervall keine, wenige oder extrem viele Teilentladungen auftreten werden. Dieser Herausforderung müssen Ortungsverfahren gerecht werden, um für den Endkunden ein aussagekräftiges Ergebnis der Ortung von Teilentladungen zu ermöglichen.

Um die Datenmengen einzugrenzen werden beispielsweise triggerbasierte Methoden angewandt, in dem für die Ortung relevante Informationen enthalten sind oder sein können. Die verbleibende Datenmenge wird dann meist einer Anzeige zugeführt, wo üblicherweise ein erfahrener Messtechniker die Ortung selbst vornimmt. Nachteilig ist dabei, dass die Auswertung erst viel später nach der erfolgten Messung vorgenommen wird. Der Grund dafür ist im enormen Zeitaufwand zu sehen, der für eine aussagekräftige Ortung im Vergleich zu der Dauer einer Datenaufnahme notwendig ist. Eventuelle Fehlmessungen können damit nur zeitaufwändig korrigiert werden, da die Messung inklusive dem Auf- und Abbau der Messeinrichtung schon aufwändig ist. Die Auswertung der Messdaten erfolgt zudem meist zeitversetzt.

Durch die Druckschrift DE 600 20 050 T2 ist ein Verfahren und eine Vorrichtung zur Ortung der Quelle von Teilentladungen bekannt, bei denen bestimmte Eigenschaften der Teilentladungsimpulse mit einem vorher experimentell erstellten Modell verglichen werden. Das Modell beschreibt die Änderung der charakteristischen Parameter in Abhängigkeit von der Strecke im Wesentlichen bei Frequenzen, bei denen Teilentladungsimpulse auftreten. Damit soll es möglich sein, den Abstand einer Quelle von Teilentladungen zum Messpunkt mit einer gewissen Genauigkeit zu bestimmen.

Eine weitere Schwierigkeit bei der Ortung ist das sichere Erkennen einer Teilentladung und einer zugehörigen Reflexion am freien oder mit einem Reflektor versehenen Kabelende. Aus der Laufzeitdifferenz zwischen der Teilentladung und ihrer zugehöriger Reflexion, welche durch das meist offene Kabelende hervorgerufen wird, kann über die bekannte oder vorgegebene Kabellänge sowie der Kabelgeschwindigkeit der zurückgelegte Weg der Teilentladung im Kabel und damit der Entstehungsort bestimmt werden. Das Problem dabei ist, dass insbesondere bei langen Kabeln die Kabeldämpfung die Teilentladung und noch mehr die zugehörige Reflexion stark dämpft. Störer, selbst mit nur kleinen Störamplituden, können damit die Ortung erschweren oder auch unmöglich machen.

Durch die Druckschrift US 2013/211750 A1 ist ein Verfahren zur Ortung von Teilentladungen in elektrischen Kabeln offenbart. Dazu ist eine Hochspannungsquelle an das zu prüfende Kabel gekoppelt. Über eine Sensoreinheit wird in einem Datenverarbeitungssystem aus den Sensorsignalen bei Vorhandensein eine Teilentladung oder Teilentladungen ermittelt. Dabei werden die Sensorsignale aus mindestens zwei Sensoren einer Wavelet Transformation unterzogen. Danach werden durch eine statistische Analyse Cluster von Teilentladungen mittels repräsantativer Parameter geformt.

Der in den Patentansprüchen 1 und 13 angegebenen Erfindung liegt die Aufgabe zugrunde, Teilentladungen in Kabeln schnell und damit direkt am Messort am Kabelende zu ermitteln.

Diese Aufgabe wird mit den in den Patentansprüchen 1 und 13 aufgeführten Merkmalen gelöst.
Die Verfahren und Einrichtungen zur Ortung von Teilentladungen in elektrischen Kabeln zeichnen sich insbesondere durch eine kurze Auswertedauer der Ortung aus.

Die Verfahren zur Ortung von Teilentladungen in elektrischen Kabeln erfolgen mittels einer an das zu prüfende Kabel gekoppelten Hochspannungsquelle, einer an ein Ende des Kabels angeschlossenen Auskoppeleinheit und einem über eine Sensoreinheit mit der Auskoppeleinheit verbundenen und aus den Sensorsignalen bei Vorhandensein eine Teilentladung oder Teilentladungen ermittelnden Datenverarbeitungssystem.

Das erfolgt mit den folgenden Schritten:
- Erkennung von Ereignissen bei deren Vorhandensein mit einem Trigger mit einem vom Störpegel abhängigen Schwellwert aus den Sensorsignalen,
- Parametrisierung der als Impulse erkannten Ereignisse, wobei Parameter der Zeitpunkt des Anfangs des Impulses, der Zeitpunkt des Endes des Impulses, die Amplitude des Impulses, der Zeitpunkt der Amplitude des Impulses, die Pulsbreite, die untere Grenzfrequenz des Impulses und die obere Grenzfrequenz des Impulses sind,
- Paarbildung der als Impulse erkannten und parametrisierten Ereignisse,
- Klassifikation der Ereignispaare, wobei die Klassifikation der die Ereignispaare repräsentierenden Impulse nach der Differenzzeit, der Amplitude, der Polarität, der Amplitudendämpfung, der Pulsbreite, der Pulsbreitendispersion, der Grenzfrequenz oder einer Kombination daraus und der Kabeldämpfung jeweils als Merkmal erfolgt,
- Zuordnung einer Teilentladung aus der Klassifikation und
- Bestimmung des Ortes der Teilentladung/en aus der Laufzeitdifferenz zwischen der jeweiligen Teilentladung und ihrer zugehörigen Reflexion.

Das Datenverarbeitungssystem ist somit
- ein mit einem Trigger mit einem vom Störpegel abhängigen Schwellwert aus den Sensorsignalen vorhandene Ereignisse als Impuls erkennendes,
- ein Parameter als Zeitpunkt des Anfangs, Zeitpunkt des Endes, Amplitude, Zeitpunkt der Amplitude, Pulsbreite, untere Grenzfrequenz des Impulses und obere Grenzfrequenz des jeweils erkannten Impulses zuordnendes,
- ein aus den erkannten und parametrisierten Ereignissen Ereignispaare bildendes,
- ein die Ereignispaare nach der Differenzzeit, der Amplitude, der Polarität, der Amplitudendämpfung, der Pulsbreite, der Pulsbreitendispersion, der Grenzfrequenz oder einer Kombination daraus und der Kabeldämpfung jeweils als Merkmal klassifizierendes,
- ein aus der Klassifikation wenigstens eine Teilentladung zuordnendes und
- ein den Ort der Teilentladung/en aus der Laufzeitdifferenz zwischen der jeweiligen Teilentladung und ihrer zugehörigen Reflexion bestimmendes Datenverarbeitungssystem.

Zur Gewinnung der Daten aus den Sensorsignalen wird vorteilhafterweise ein Trigger mit seinem charakeristischen Triggerverfahren genutzt. Der Trigger löst eine Datenaufnahme mit möglichst geringer Datenmenge aus. Da der Trigger und das Triggerverfahren selbst keine Kenntnis besitzt, ob das Triggersignal als Impuls durch eine Teilentladung, deren Reflexion oder durch einen Störer auslöst wurde, werden bestimmte Merkmale zur Ermittlung der Teilentladungen und deren Reflexionen herangezogen.

Für die Ortsbestimmung wird die Laufzeitdifferenz zwischen Teilentladung und ihrer zugehörigen Reflexion benötigt. Diese Laufzeitdifferenz kann aus den Zeitpunkten des Eintreffens von Impulsen aus der Teilentladung und der Reflexion gewonnen werden. Weiterhin besteht eine Relation zwischen empfangenen Impuls aus der Teilentladung und aus der zugehörigen empfangenen Reflexion. Diese basieren beispielsweise auf der Kabeldämpfung und der Pulsbreitendispersion zwischen Teilentladung und Reflexion. Diese Relation von mehreren Datensätzen wird ebenfalls mit einbezogen. Da nicht sichergestellt werden kann, dass zwei zeitlich aufeinanderfolgende Impulse und damit über die Sensoreinheit ermittelte Datensätze eine Teilentladung und im nachfolgenden Datensatz die Reflexion enthalten, werden die Merkmale der Datensätze mit einander zu einem Merkmalssatzpaar kombiniert. Anschließend wird die Relation der Merkmalspaare oder der Merkmalssatzpaare zueinander geprüft. Diese Prüfungen führen zu einer weiteren Reduktion der Datenmenge, so dass im Ergebnis nach diesen Prüfungen Merkmalssatzpaare vorliegen, die mit hoher Wahrscheinlichkeit einem Teilentladungsereignis, bestehend aus den Impulsen der Teilentladung mit zugehöriger Reflexion entsprechen.

Die automatisch ermittelte Auftrittswahrscheinlichkeit ist ebenso ein Maß für die Kritikalität des physikalischen Schädlingsprozesses innerhalb des Kabels.

Mit dem Verfahren und der Einrichtung sind damit Teilentladungen in Kabeln vorteilhafterweise schnell und direkt am Messort am Kabelende zu ermitteln. Das Verfahren und die Einrichtung eignen sich damit insbesondere für Energiekabel als Kabel.

Vorteilhafte Ausgestaltungen der Erfindung sind in den Patentansprüchen 2 bis 12 angegeben.

Zur Zuordnung einer Teilentladung im Datenverarbeitungssystem werden nach der Weiterbildung des Patentanspruchs 2 weiterhin Merkmale über die Häufigkeit von Ereignispaaren an einem Ort oder in einem Ortsintervall statistisch ausgewertet, wobei die Häufigkeit der Ereignispaare ein Maß für die Wahrscheinlichkeit einer aufgetretenen Teilentladung ist.

Damit kann das Ortungsergebnis verbessert werden. Die verbleibenden Merkmalssatzpaare werden einer statistischen Auswertung unterzogen. Teilentladungsereignisse können am selben Ort oder mit derselben Laufzeitdifferenz zwischen Teilentladung und Reflexion auftreten. Messungenauigkeiten können durch die statistische Auswertung über Konfidenzintervalle der Messparameter berücksichtig werden. Bei Merkmalspaaren, welche nicht einer Teilentladung zugrunde liegen, variiert der gemessene Ort oder die Laufzeitdifferenz sehr stark. Liegen beispielsweise Merkmalspaare vor, welche zu gleichem Anteil einer Teilentladung und Störern zugehörig sind, kann über die statistische Auswertung mittels der Häufigkeit der Merkmalspaare an einem Ort oder Ortsintervall entschieden werden, ob es sich dabei mit sehr hoher Wahrscheinlichkeit um ein Ereignis aus einer Teilentladung oder einem Störer handelt. Dabei muss diese Entscheidung nicht starr auf richtig oder falsch hinauslaufen, sondern es können weitere Zwischenstufen in Abhängigkeit der Häufigkeit der Merkmalspaare im Ortsintervall eingeführt werden. Je höher die Häufigkeit der Merkmalspaare, je höher ist die Wahrscheinlichkeit, dass es sich dabei tatsächlich um Ereignisse aus Teilentladungen handelt.

Das Ortungsergebnis wird nach der Weiterbildung des Patentanspruchs 3 über ein Mapping angezeigt, wobei im Mapping eine Punktwolke mit Punkten des Ortungsergebnisses in Abhängigkeit von dem Ort, der Amplitude und der Häufigkeit der Ereignispaare an einem Ort oder in einem Ortsintervall auf einem mit dem Datenverarbeitungssystem verbundenen Anzeigegerät dargestellt wird. Beispielsweise kann die Dimension ein dreidimensionales Mapping sein, mit den Dimensionen Amplitude, Ort und Häufigkeit.

In Fortführung wird den Punkten nach der Weiterbildung des Patentanspruchs 4 entsprechend ihrer Häufigkeit eine Farbe zugeordnet. Mit der farblichen Aufprägung wird die Aufmerksamkeit der Endanwender auf die Ereignisse gelenkt, welche mit sehr hoher Wahrscheinlichkeit den tatsächlichen Ereignissen aus den Teilentladungen entsprechen.

Die Erkennung der Ereignisse hängt nach der Weiterbildung des Patentanspruchs 5 von dem an die Störleistung angepassten Schwellwert des Triggers ab, wobei sich mittels eines Empfindlichkeitsparameters der Schwellwert in Abhängigkeit der Störleistung ergibt und die Störleistung unter Annahme von mittelwertfreien gaußverteilten Rauschen über die Daten aus den Sensorsignalen abschätzbar ist.

Bei der Parametrisierung werden nach der Weiterbildung des Patentanspruchs 6 Anfang und Ende des Impulses des erkannten Ereignisses über die Detektion der Nulldurchgänge vor und nach dem Zeitpunkt des Impulses bestimmt, wobei eventuelle Amplitudenvariationen mit gleichem Anfang und Ende eliminiert werden.

Die Differenzzeit zur Klassifikation ist nach der Weiterbildung des Patentanspruchs 7 die Zeit eines Intervalls bestimmt durch den Impuls aus der Teilentladung und den Impuls aus der Reflexion, wobei eine obere Grenze durch die Kabellänge und der Kabelgeschwindigkeit bestimmt ist.

Die Amplitude des Impulses ist nach der Weiterbildung des Patentanspruchs 8 zur Klassifikation durch das Rauschen und durch die Auskoppeleinheit begrenzt.

Die Reflexion des Impulses der Teilentladung erfolgt nach der Weiterbildung des Patentanspruchs 9 am offenen Kabelende, so dass der Reflexionsfaktor positiv ist und der Impuls der Reflexion die gleiche Polarität besitzt.

Die Amplitudendämpfung der Impulse der Teilentladung und der Reflexion befindet sich nach der Weiterbildung des Patentanspruchs 10 in einem von der Differenzzeit abhängigen Intervall.

Die Pulsbreitendispersion ergibt sich nach der Weiterbildung des Patentanspruchs 11 aus der Abhängigkeit der Pulsbreite der Reflexion von der Pulsbreite der Teilentladung und aus den Kabeleigenschaften.

Zur Zuordnung einer Teilentladung werden nach der Weiterbildung des Patentanspruchs 12 im Datenverarbeitungssystem weiterhin Merkmale der klassifizierten Ereignispaare mit in einem Speicher abgelegten Referenzereignispaaren und/oder Merkmale wenigstens eines vorhandenen Ereignisses aus den klassifizierten Ereignispaaren mit in einem Speicher des Datenverarbeitungssystems enthaltenen Referenzmerkmalen verglichen.

Ein Ausführungsbeispiel der Erfindung ist in den Zeichnungen jeweils prinzipiell dargestellt und wird im Folgenden näher beschrieben.

Es zeigen:
- Fig. 1: eine Einrichtung zur Ortung von Teilentladungen in elektrischen Kabeln,
- Fig. 2: Ereignissen zuordenbare Sensorsignale am Ausgang der Auskoppeleinheit der Einrichtung,
- Fig. 3: ein Histogramm einer Ortung von Teilentladungen und
- Fig. 4: ein Mapping dieser Ortung.

Im nachfolgenden Ausführungsbeispiel werden ein Verfahren und eine Einrichtung zur Ortung von Teilentladungen in elektrischen Kabeln zusammen näher erläutert.

Eine Einrichtung zur Ortung von Teilentladungen 6 in elektrischen Kabeln 2 besteht im Wesentlichen aus einer Hochspannungsquelle 1, einer Auskoppeleinheit 3, einer Sensoreinheit 4 und einem Datenverarbeitungssystem 5.

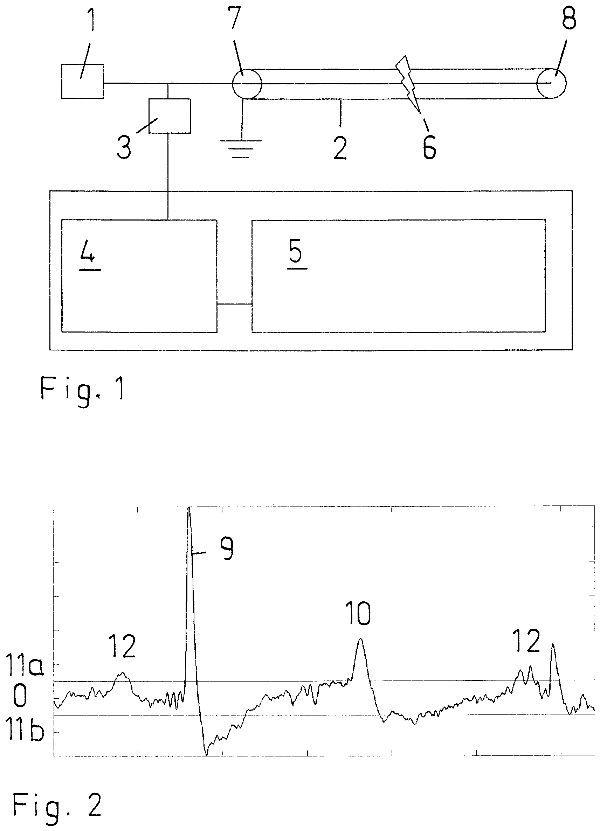

Die Fig. 1 zeigt eine Einrichtung zur Ortung von Teilentladungen 6 in elektrischen Kabeln 2 in einer prinzipiellen Darstellung.

An das zu prüfende Kabel 2 ist die Hochspannungsquelle 1 angekoppelt. Mittels dieser wird eine Hochspannung von bis zu einigen 100 Kilovolt an das zu prüfende Kabel 2 angelegt. Die Spannungsform kann dazu eine Gleichspannung, eine niederfrequente Sinusspannung, eine Spannung als gedämpfte Schwingung oder eine Cosinus-Rechteck-Spannung sein. Darüber hinaus kann auch die 50/60 Hz Netzspannung eines Energieversorgers benutzt werden.

Die Fig. 2 zeigt Ereignissen zuordenbare Sensorsignale am Ausgang der Auskoppeleinheit 3 der Einrichtung in einer prinzipiellen Darstellung.

Die Hochspannung führt an Schwachstellen des Isoliermediums des zu prüfenden Kabels 2 zu inhomogenen elektrischen Feldern. Überschreitet die elektrische Feldstärke im Isoliermedium einen kritischen Wert kommt es zu einem unvollkommen elektrischen Durchschlag 6, welcher auch unter dem Begriff der Teilentladung 6 bekannt ist. Die Teilentladung 6 breitet sich in beiden Richtungen des Kabels 2 aus, wobei an einem Kabelende 7 die Auskoppeleinheit 3 für Teilentladungen 6 angeschlossen ist. Diese ist weiterhin über die Sensoreinheit 4 mit dem Datenverarbeitungssystem 5 als Auswerteeinheit zusammengeschaltet. Das andere Ende des Kabels 8 ist für die Ortung offen, so dass der Teil der Teilentladung 6, welcher in Richtung des offenen Kabelendes 8 gelaufen ist, an diesem Ende 8 reflektiert. Die Reflexion des Impulses 9 der Teilentladung 6 am offenen Kabelende 8 erfolgt so, dass der Reflexionsfaktor positiv ist und der Impuls 10 der Reflexion die gleiche Polarität besitzt. Das reflektierte Signal 10 wird ebenfalls am anderen Ende 7 des Kabels 2 von der Auskoppeleinheit 3 empfangen und über die Sensoreinheit 4 dem Datenverarbeitungssystem 5 zugeführt.

Die Sensoreinheit 4 umfasst einen Sensor zur Erfassung der Teilentladungsströme und Verstärker sowie Filteranordnungen. Die Sensoreinheit 4 selbst liefert ein digitales Signal oder das Signal wird über einen bekannten Analog-Digital-Wandler in ein digitales Signal gewandelt.

Im Datenverarbeitungssystem 5 erfolgt eine Erkennung von Ereignissen bei deren Vorhandensein mit einem Trigger mit vom Störpegel abhängigen Schwellwerten 11a, 11b aus den Sensorsignalen. Der jeweilige Schwellwert 11a, 11b ist dazu anpassbar, wobei sich mittels eines Empfindlichkeitsparameters der Schwellwerte 11a, 11b in Abhängigkeit der Störleistung ergibt und die Störleistung unter Annahme von mittelwertfreien gaußverteilten Rauschen über die Daten aus den Sensorsignalen abschätzbar ist.

Die als Impulse 9, 10, 12 erkannten Ereignisse werden parametrisiert, wobei Parameter der Zeitpunkt des Anfangs des Impulses 9, 10, 12, der Zeitpunkt des Endes des Impulses 9, 10, 12, die Amplitude des Impulses 9, 10, 12, der Zeitpunkt der Amplitude des Impulses 9, 10, 12, die Pulsbreite, die untere Grenzfrequenz des Impulses 9, 10, 12 und die obere Grenzfrequenz des Impulses 9, 10, 12 sind.

Bei der Parametrisierung werden Anfang und Ende des Impulses 9, 10, 12 des erkannten Ereignisses über die Detektion der Nulldurchgänge vor und nach dem Zeitpunkt des Impulses 9, 10, 12 bestimmt. Ein Impuls wird damit definiert, dass dieser durch seine Nulldurchgänge zeitlich abgeschlossen ist. Durch im Messsignal enthaltenen Amplitudenvariationen hervorgerufene mehrfache Triggerung, welche auf zeitlich denselben Nulldurchgängen zurückzuführen sind, werden nur als ein Ereignis (Impuls) gewertet.

Anschließend erfolgt eine Paarbildung der als Impulse 9, 10, 12 erkannten und parametrisierten Ereignisse, die nachfolgend klassifiziert werden. Die Klassifikation der die Ereignispaare repräsentierenden Impulse 9, 10, 12 erfolgt nach der Differenzzeit, der Amplitude, der Polarität, der Amplitudendämpfung, der Pulsbreite, der Pulsbreitendispersion, der Grenzfrequenz oder einer Kombination daraus und der Kabeldämpfung jeweils als Merkmal. Die Differenzzeit ist zur Klassifikation die Zeit eines Intervalls bestimmt durch den Impuls 9 aus der Teilentladung 6 und den Impuls 10 aus der Reflexion, wobei eine obere Grenze durch die Kabellänge und der Kabelgeschwindigkeit bestimmt ist. Die Amplitudendämpfung der Impulse 9, 10 der Teilentladung 6 und der Reflexion befindet sich dabei in einem von der Differenzzeit abhängigen Intervall. Die Pulsbreitendispersion aus der Abhängigkeit der Pulsbreite der Reflexion ergibt sich von der Pulsbreite der Teilentladung 6 und aus den Kabeleigenschaften.

Über eine Zuordnung einer Teilentladung 6 aus der Klassifikation wird der Ort der Teilentladung/en 6 aus der Laufzeitdifferenz zwischen der jeweiligen Teilentladung 6 und ihrer zugehörigen Reflexion bestimmt, wobei Störimpulse 12 ausgeschlossen sind.

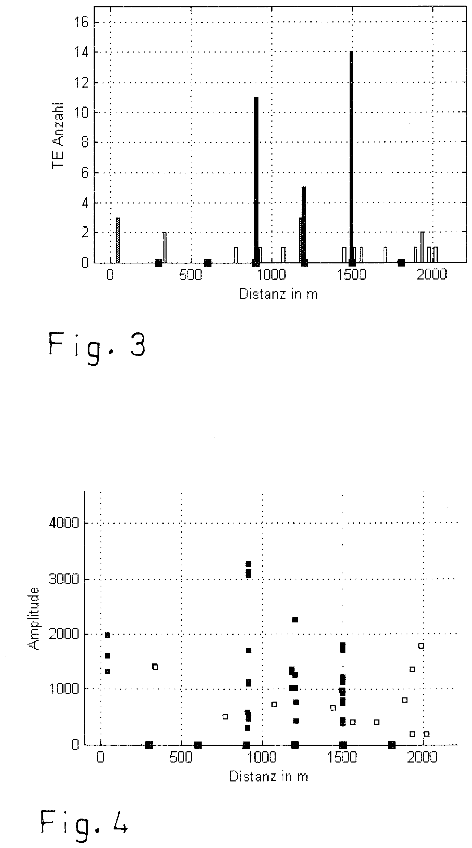

Die Fig. 3 zeigt ein Histogramm einer Ortung von Teilentladungen 6 in einer prinzipiellen Darstellung.

Zur Zuordnung einer Teilentladung 6 im Datenverarbeitungssystem 5 werden weiterhin Merkmale über die Häufigkeit von Ereignispaaren an einem Ort oder in einem Ortsintervall statistisch ausgewertet, wobei die Häufigkeit der Ereignispaare ein Maß für die Wahrscheinlichkeit einer aufgetretenen Teilentladung 6 ist.

Die Fig. 4 zeigt ein Mapping dieser Ortung in einer prinzipiellen Darstellung.

Das Ortungsergebnis kann über ein Mapping angezeigt werden, wobei im Mapping eine Punktwolke mit Punkten des Ortungsergebnisses in Abhängigkeit von dem Ort, der Amplitude und der Häufigkeit der Ereignispaare an einem Ort oder in einem Ortsintervall auf einem mit dem Datenverarbeitungssystem 5 verbundenen Anzeigegerät dargestellt wird. Den Punkten kann entsprechend ihrer Häufigkeit eine Farbe zugeordnet sein.

In einer Ausführungsform können zur Zuordnung einer Teilentladung 6 im Datenverarbeitungssystem 5 weiterhin Merkmale der klassifizierten Ereignispaare mit in einem Speicher abgelegten Referenzereignispaaren und/oder Merkmale wenigstens eines vorhandenen Ereignisses aus den klassifizierten Ereignispaaren mit in einem Speicher des Datenverarbeitungssystems 5 enthaltenen Referenzmerkmalen verglichen werden.

## Patentansprüche

1. Verfahren zur Ortung von Teilentladungen (6) in elektrischen Kabeln (2) mit einer an das zu prüfende Kabel (2) gekoppelten Hochspannungsquelle (1), einer an ein Ende (7) des Kabels (2) angeschlossenen Auskoppeleinheit (3) und einem über eine Sensoreinheit (4) mit der Auskoppeleinheit (3) verbundenen und aus den Sensorsignalen bei Vorhandensein eine Teilentladung (6) oder Teilentladungen (6) ermittelnden Datenverarbeitungssystem (5), **dadurch gekennzeichnet,**
- **dass** Ereignisse bei deren Vorhandensein mit einem Trigger mit einem vom Störpegel abhängigen Schwellwert (11a, 11b) aus den Sensorsignalen vorhandene Ereignisse als Impulse erkannt werden,
- **dass** die als Impulse (9, 10, 12) erkannten Ereignisse parametrisiert werden, wobei Parameter der Zeitpunkt des Anfangs des Impulses (9, 10, 12), der Zeitpunkt des Endes des Impulses (9, 10, 12), die Amplitude des Impulses (9, 10, 12), der Zeitpunkt der Amplitude des Impulses (9, 10, 12), die Pulsbreite, die untere Grenzfrequenz des Impulses (9, 10, 12) und die obere Grenzfrequenz des Impulses (9, 10, 12) sind,
- **dass** Paare der als Impulse (9, 10, 12) erkannten und parametrisierten Ereignisse gebildet werden,
- **dass** die Ereignispaare klassifiziert werden, wobei die Klassifikation der die Ereignispaare repräsentierenden Impulse (9, 10, 12) nach der Differenzzeit, der Amplitude, der Polarität, der Amplitudendämpfung, der Pulsbreite, der Pulsbreitendispersion, der Grenzfrequenz oder einer Kombination daraus und der Kabeldämpfung jeweils als Merkmal erfolgt,
- **dass** eine Teilentladung (6) aus der Klassifikation zugeordnet wird und
- **dass** der Ort der Teilentladung/en (6) aus der Laufzeitdifferenz zwischen der jeweiligen Teilentladung (6) und ihrer zugehörigen Reflexion bestimmt wird.

2. Verfahren nach Patentanspruch 1, **dadurch gekennzeichnet, dass** zur Zuordnung einer Teilentladung (6) im Datenverarbeitungssystem (5) weiterhin Merkmale über die Häufigkeit von Ereignispaaren an einem Ort oder in einem Ortsintervall statistisch ausgewertet werden, wobei die Häufigkeit der Ereignispaare ein Maß für die Wahrscheinlichkeit einer aufgetretenen Teilentladung (6) ist.

3. Verfahren nach wenigstens einem der Patentansprüche 1 und 2, **dadurch gekennzeichnet, dass** das Ortungsergebnis über ein Mapping angezeigt wird, wobei im Mapping eine Punktwolke mit Punkten des Ortungsergebnisses in Abhängigkeit von dem Ort, der Amplitude und der Häufigkeit der Ereignispaare an einem Ort oder in einem Ortsintervall auf einem mit dem Datenverarbeitungssystem (5) verbundenen Anzeigegerät dargestellt wird.

4. Verfahren nach Patentanspruch 3, **dadurch gekennzeichnet, dass** den Punkten entsprechend ihrer Häufigkeit eine Farbe zugeordnet wird.

5. Verfahren nach Patentanspruch 1, **dadurch gekennzeichnet, dass** die Erkennung der Ereignisse von dem an die Störleistung angepassten Schwellwert (11a, 11b) des Triggers abhängt, wobei sich mittels eines Empfindlichkeitsparameters der Schwellwert (11a, 11b) in Abhängigkeit der Störleistung ergibt und die Störleistung unter Annahme von mittelwertfreien gaußverteilten Rauschen über die Daten aus den Sensorsignalen abschätzbar ist.

6. Verfahren nach Patentanspruch 1, **dadurch gekennzeichnet, dass** bei der Parametrisierung Anfang und Ende des Impulses (9, 10, 12) des erkannten Ereignisses über die Detektion der Nulldurchgänge vor und nach dem Zeitpunkt des Impulses (9, 10, 12) bestimmt werden, wobei eventuelle Amplitudenvariationen mit gleichem Anfang und Ende eliminiert werden.

7. Verfahren nach Patentanspruch 1, **dadurch gekennzeichnet, dass** die Differenzzeit zur Klassifikation die Zeit eines Intervalls bestimmt durch den Impuls (9) aus der Teilentladung (6) und den Impuls (10) aus der Reflexion ist, wobei eine obere Grenze durch die Kabellänge und der Kabelgeschwindigkeit bestimmt ist.

8. Verfahren nach Patentanspruch 1, **dadurch gekennzeichnet, dass** die Amplitude des Impulses (9, 10, 12) zur Klassifikation durch das Rauschen und durch die Auskoppeleinheit begrenzt ist.

9. Verfahren nach Patentanspruch 1, **dadurch gekennzeichnet, dass** die Reflexion des Impulses (9) der Teilentladung (6) am offenen Kabelende (8) erfolgt, so dass der Reflexionsfaktor positiv ist und der Impuls (10) der Reflexion die gleiche Polarität besitzt.

10. Verfahren nach Patentanspruch 1 und 8, **dadurch gekennzeichnet, dass** sich die Amplitudendämpfung des Impulses (9) der Teilentladung (6) und des Impulses (10) der Reflexion in einem von der Differenzzeit abhängigen Intervall befindet.

11. Verfahren nach Patentanspruch 1, **dadurch gekennzeichnet, dass** sich die Pulsbreitendispersion aus der Abhängigkeit der Pulsbreite der Reflexion von der Pulsbreite der Teilentladung (6) und aus den Kabeleigenschaften ergibt.

12. Verfahren nach Patentanspruch 1 bis 11, **dadurch gekennzeichnet, dass** zur Zuordnung einer Teilentladung (6) im Datenverarbeitungssystem (5) weiterhin Merkmale der klassifizierten Ereignispaare mit in einem Speicher abgelegten Referenzereignispaaren und/oder Merkmale wenigstens eines vorhandenen Ereignisses aus den klassifizierten Ereignispaaren mit in einem Speicher des Datenverarbeitungssystems (5) enthaltenen Referenzmerkmalen verglichen werden.

13. Einrichtung zur Ortung von Teilentladungen (6) in elektrischen Kabeln (2) mit dem Verfahren nach Anspruch 1 mit einer an das zu prüfende Kabel (2) gekoppelten Hochspannungsquelle (1), einer an ein Ende (7) des Kabels (2) angeschlossenen Auskoppeleinheit (3), einem über eine Sensoreinheit (4) mit der Auskoppeleinheit (3) verbundenen und aus den Sensorsignalen bei Vorhandensein eine Teilentladung (6) oder Teilentladungen (6) ermittelnden Datenverarbeitungssystem (5), **dadurch gekennzeichnet,**
**dass** das Datenverarbeitungssystem (5)
- ein mit einem Trigger mit einem vom Störpegel abhängigen Schwellwert (11a, 11b) aus den Sensorsignalen vorhandene Ereignisse als Impuls (9, 10, 12) erkennendes,
- ein Parameter als Zeitpunkt des Anfangs, Zeitpunkt des Endes, Amplitude, Zeitpunkt der Amplitude, Pulsbreite, untere Grenzfrequenz des Impulses (9, 10, 12) und obere Grenzfrequenz des jeweils erkannten Impulses (9, 10, 12) zuordnendes,
- ein aus den erkannten und parametrisierten Ereignissen Ereignispaare bildendes,
- ein die Ereignispaare nach der Differenzzeit, der Amplitude, der Polarität, der Amplitudendämpfung, der Pulsbreite, der Pulsbreitendispersion, der Grenzfrequenz oder einer Kombination daraus und der Kabeldämpfung jeweils als Merkmal klassifizierendes,
- ein aus der Klassifikation wenigstens eine Teilentladung (6) zuordnendes und
- ein den Ort der Teilentladung/en (6) aus der Laufzeitdifferenz zwischen der jeweiligen Teilentladung (6) und ihrer zugehörigen Reflexion bestimmendes Datenverarbeitungssystem (5) ist.

## Claims

1. Method for locating partial discharges (6) in electrical cables (2) by means of a high-voltage source (1) that is coupled to the cable (2) to be tested, a decoupling unit (3) that is connected to one end (7) of the cable (2), and a data processing system (5) that is connected to the decoupling unit (3) via a sensor unit (4) and determines a partial discharge (6) or partial discharges (6), when present, from the sensor signals, **characterised**
- **in that** events, if present, are identified as pulses from the sensor signals by means of a trigger having a threshold value (11a, 11b) that is dependent on the interference level,
- **in that** the events that are identified as pulses (9, 10, 12) are parameterised, parameters being the instant of the start of the pulse (9, 10, 12), the instant of the end of the pulse (9, 10, 12), the amplitude of the pulse (9, 10, 12), the instant of the amplitude of the pulse (9, 10, 12), the pulse width, the lower cutoff frequency of the pulse (9, 10, 12) and the upper cutoff frequency of the pulse (9, 10, 12),
- **in that** pairs of events that are identified as pulses (9, 10, 12) and parameterised are formed,
- **in that** the event pairs are classified, the pulses (9, 10, 12) that represent the event pairs being classified according to the differential time, the amplitude, the polarity, the amplitude attenuation, the pulse width, the pulse width dispersion, the cutoff frequency or a combination thereof and the cable attenuation as a feature in each case,
- **in that** a partial discharge (6) is assigned from the classification, and
- **in that** the location of the partial discharge/s (6) is determined from the difference in transit times between said partial discharge (6) and the associated reflection thereof.

2. Method according to claim 1, **characterised in that** features relating to the frequency of occurrence of event pairs at a location or in a location interval are furthermore statistically evaluated in order to assign a partial discharge (6) in the data processing system (5), the frequency of occurrence of the event pairs being a measure of the probability that a partial discharge (6) has occurred.

3. Method according to at least one of claims 1 and 2, **characterised in that** the location result is displayed by means of a mapping, a point cloud that has points of the location result being shown in the mapping on a display device that is connected to the data processing system (5), depending on the location, the amplitude and the frequency of the event pairs at one location or in a local interval.

4. Method according to claim 3, **characterised in that** a colour is assigned to the points according to the frequency of occurrence of said points.

5. Method according to claim 1, **characterised in that** the identification of the events is dependent on the threshold value (11a, 11b) of the trigger, which threshold value is adapted to the interference power, the threshold value (11a, 11b) being determined depending on the interference power by means of a sensitivity parameter and it being possible to estimate the interference power by using the data from the sensor signals, with an assumption of zero-mean Gaussian noise.

6. Method according to claim 1, **characterised in that**, during the parameterisation, the start and end of the pulse (9, 10, 12) of the identified event are determined by detecting the zero crossings before and after the instant of the pulse (9, 10, 12), possible amplitude variations having the same start and end being eliminated.

7. Method according to claim 1, **characterised in that** the differential time for the classification is the time period of an interval that is determined by means of the pulse (9) from the partial discharge (6) and the pulse (10) from the reflection, an upper limit being determined by means of the cable length and the cable speed.

8. Method according to claim 1, **characterised in that** the amplitude of the pulse (9, 10, 12) is limited for the classification by the noise and by the decoupling unit.

9. Method according to claim 1, **characterised in that** the reflection of the pulse (9) of the partial discharge (6) occurs at the open cable end (8) such that the reflection factor is positive and the pulse (10) of the reflection has the same polarity.

10. Method according to claims 1 and 8, **characterised in that** the amplitude attenuation of the pulse (9) of the partial discharge (6) and of the pulse (10) of the reflection is in an interval that is dependent on the differential time.

11. Method according to claim 1, **characterised in that** the pulse width dispersion results from the dependence of the pulse width of the reflection on the pulse width of the partial discharge (6) and from the cable properties.

12. Method according to claims 1 to 11, **characterised in that** features of the classified event pairs are also compared with reference event pairs stored in a memory, and/or features of at least one present event from the classified event pairs are compared with reference features contained in a memory of the data processing system (5) in order to assign a partial discharge (6) in the data processing system (5).

13. Device for locating partial discharges (6) in electrical cables (2) by means of the method according to claim 1, said device comprising a high-voltage source (1) that is coupled to the cable (2) to be tested, a decoupling unit (3) that is connected to one end (7) of the cable (2), and a data processing system (5) that is connected to the decoupling unit (3) via a sensor unit (4) and determines a partial discharge (6) or partial discharges (6), when present, from the sensor signals, **characterised in that** the data processing system (5) is a data processing system (5) that
- identifies present events as a pulse (9, 10, 12) from the sensor signals by means of a trigger having a threshold value (11a, 11b) that is dependent on the interference level,
- assigns a parameter as the instant of the start, instant of the end, amplitude, instant of the amplitude, pulse width, lower cutoff frequency of the pulse (9, 10, 12) and upper cutoff frequency of the pulse (9, 10, 12) that is identified in each case,
- forms an event pair from the identified and parameterised events,
- classifies the event pairs according to the differential time, the amplitude, the polarity, the amplitude attenuation, the pulse width, the pulse width dispersion, the cutoff frequency or a combination thereof and the cable attenuation as a feature in each case,
- assigns at least one partial discharge (6) from the classification, and
- determines the location of the partial discharge/s (6) from the difference in transit times between said partial discharge (6) and the associated reflection thereof.

## Revendications

1. Procédé de localisation de décharges partielles (6) dans des câbles électriques (2) à l'aide d'une source haute tension (1) couplée au câble à contrôler (2), d'une unité de découplage (3) raccordée à une extrémité (7) du câble (2) et d'un système de traitement de données (5), lequel est relié à l'unité de découplage (3) par l'intermédiaire d'une unité de capteur (4) et détermine une décharge partielle (6) ou des décharges partielles (6) à partir des signaux de capteur s'ils sont présents, **caractérisé**
- **en ce que** des événements, s'ils sont présents, sont identifiés comme impulsions à partir des signaux de capteur à l'aide d'un déclencheur comportant une valeur de seuil (11a, 11b) qui dépend du niveau d'interférence,
- **en ce que** les événements identifiés comme impulsions (9, 10, 12) sont paramétrés, les paramètres étant l'instant de début de l'impulsion (9, 10, 12), l'instant de fin de l'impulsion (9, 10, 12), l'amplitude de l'impulsion (9, 10, 12), l'instant de l'amplitude de l'impulsion (9, 10, 12), la largeur d'impulsion, la fréquence limite inférieure de l'impulsion (9, 10, 12) et la fréquence limite supérieure de l'impulsion (9, 10, 12),
- **en ce que** des paires des événements identifiés comme impulsions (9, 10, 12) et paramétrés sont formées,
- **en ce que** les paires d'événements sont classifiées, la classification des impulsions représentant les paires d'événements (9, 10, 12) étant effectuée selon le temps différentiel, l'amplitude, la polarité, l'atténuation d'amplitude, la largeur d'impulsion, la dispersion de largeur d'impulsion, la fréquence limite ou une combinaison de ceux-ci et l'atténuation de câble, respectivement comme caractéristique,
- **en ce qu'**une décharge partielle (6) est affectée à partir de la classification, et
- **en ce que** l'emplacement de la ou des décharges partielles (6) est déterminé à partir de la différence de durée entre la décharge partielle respective (6) et sa réflexion associée.

2. Procédé selon la revendication 1, **caractérisé en ce que**, pour affecter une décharge partielle (6) dans le système de traitement de données (5), des caractéristiques concernant la fréquence des paires d'événements à un emplacement ou dans un intervalle d'emplacements sont en outre évaluées statistiquement, la fréquence des paires d'événements étant une grandeur de la probabilité d'une décharge partielle (6) survenue.

3. Procédé selon au moins l'une des revendications 1 et 2, **caractérisé en ce que** le résultat de la localisation est affiché par l'intermédiaire d'un mappage, un nuage de points comportant des points du résultat de la localisation étant représenté dans le mappage en fonction de l'emplacement, de l'amplitude et de la fréquence des paires d'événements à un emplacement ou dans un intervalle d'emplacements sur un appareil d'affichage relié au système de traitement de données (5).

4. Procédé selon la revendication 3, **caractérisé en ce qu'**une couleur est affectée aux points en fonction de leur fréquence.

5. Procédé selon la revendication 1, **caractérisé en ce que** l'identification des événements dépend de la valeur de seuil (11a, 11b) du déclencheur qui est adaptée à la puissance d'interférence, la valeur de seuil (11a, 11b) étant obtenue en fonction de la puissance d'interférence au moyen d'un paramètre de sensibilité, et la puissance d'interférence pouvant être estimée par l'intermédiaire des données provenant des signaux de capteur, en supposant un bruit à distribution gaussienne sans valeur moyenne.

6. Procédé selon la revendication 1, **caractérisé en ce que**, lors du paramétrage, le début et la fin de l'impulsion (9, 10, 12) de l'événement identifié concernant la détection des passages par zéro sont déterminés avant et après l'instant de l'impulsion (9, 10, 12), des variations éventuelles d'amplitude ayant le même début et la même fin étant éliminées.

7. Procédé selon la revendication 1, **caractérisé en ce que** le temps différentiel pour la classification est le temps d'un intervalle déterminé par l'impulsion (9) à partir de la décharge partielle (6) et l'impulsion (10) à partir de la réflexion, une limite supérieure étant déterminée par la longueur de câble et la vitesse de câble.

8. Procédé selon la revendication 1, **caractérisé en ce que** l'amplitude de l'impulsion (9, 10, 12) pour la classification est limitée par le bruit et par l'unité de découplage.

9. Procédé selon la revendication 1, **caractérisé en ce que** la réflexion de l'impulsion (9) de la décharge partielle (6) se produit à l'extrémité ouverte (8) du câble, de telle sorte que le facteur de réflexion est positif, et que l'impulsion (10) de la réflexion présente la même polarité.

10. Procédé selon la revendication 1 et 8, **caractérisé en ce que** l'atténuation d'amplitude de l'impulsion (9) de la décharge partielle (6) et de l'impulsion (10) de la réflexion se trouve dans un intervalle dépendant du temps différentiel.

11. Procédé selon la revendication 1, **caractérisé en ce que** la dispersion de largeur d'impulsion résulte de la dépendance de la largeur d'impulsion de la réflexion à la largeur d'impulsion de la décharge partielle (6), et des propriétés du câble.

12. Procédé selon la revendication 1 à 11, **caractérisé en ce que**, pour affecter une décharge partielle (6) dans le système de traitement de données (5), des caractéristiques des paires d'événements classifiées sont en outre comparées avec des paires d'événements de référence enregistrées dans une mémoire, et/ou des caractéristiques d'au moins un événement présent parmi les paires d'événements classifiées sont comparées avec des caractéristiques de référence contenues dans une mémoire du système de traitement de données (5).

13. Dispositif de localisation de décharges partielles (6) dans des câbles électriques (2) par le procédé selon la revendication 1 à l'aide d'une source haute tension (1) couplée au câble à contrôler (2), d'une unité de découplage (3) raccordée à une extrémité (7) du câble (2) et d'un système de traitement de données (5), lequel est relié à l'unité de découplage (3) par l'intermédiaire d'une unité de capteur (4) et détermine une décharge partielle (6) ou des décharges partielles (6) à partir des signaux de capteur s'ils sont présents, **caractérisé en ce que** le système de traitement de données (5) est un système de traitement de données (5)
- qui identifie des événements présents sous forme d'impulsion (9, 10, 12) à partir des signaux de capteur à l'aide d'un déclencheur comportant une valeur de seuil (11a, 11b) dépendant du niveau d'interférence,
- qui affecte un paramètre comme instant du début, instant de la fin, amplitude, instant de l'amplitude, largeur d'impulsion, fréquence limite inférieure de l'impulsion (9, 10, 12) et fréquence limite supérieure de l'impulsion (9, 10, 12) respectivement identifiée,
- qui forme une paire d'événements à partir des événements identifiés et paramétrés,
- qui classifie les paires d'événements selon le temps différentiel, l'amplitude, la polarité, l'atténuation d'amplitude, la largeur d'impulsion, la dispersion de largeur d'impulsion, la fréquence limite ou une combinaison de ceux-ci et l'atténuation de câble, respectivement comme caractéristique,
- qui affecte au moins une décharge partielle (6) à partir de la classification, et
- qui détermine l'emplacement de la ou des décharges partielles (6) à partir de la différence de durée entre la décharge partielle respective (6) et sa réflexion associée.
